# EUROPEAN PATENT APPLICATION

(11) **EP 4 600 792 A1**
(43) Date of publication of application: **13.08.2025**
(21) Application number: 23950102.6
(22) Date of filing: 30.08.2023
(51) Int. Cl.: G06F 3/041

(54) **TOUCH DISPLAY PANEL AND DISPLAY APPARATUS**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: CUI, Guoyi, Beijing 100176 (CN); GAO, Tao, Beijing 100176 (CN); WANG, Yanqiang, Beijing 100176 (CN); GUI, Bingqiang, Beijing 100176 (CN)
(74) Representative: Haseltine Lake Kempner LLP
(86) International application number: PCT/CN2023/115642
(87) International publication number: WO 2025/043511

(57) **Abstract**

Provided is a touch display panel, belonging to the field of display technologies. The display substrate (101) includes: a base substrate (1011) having pixel units (1012), dimming portions (1013), a first barrier structure (1014), and a first filling portion (1015). An orthographic projection of each dimming portion (1013) is overlapped with an orthographic projection of a light-emitting region of a corresponding pixel units (1012) on the base substrate (1011). Light from the light-emitting region is exited through the dimming portion (1013). The first filling portion (1015) is disposed on a target side of the first barrier structure (1014), which includes at least one of a side, close to the display region (1011a), of the first barrier structure (1014) or a side, away from the display region (1011a), of the first barrier structure (1014). The first filling portion (1015) and the dimming portions (1013) are disposed in a same layer.

## Description

### TECHNICAL FIELD

The present disclosure relates to the field of display technologies, and in particular, relates to a touch display panel and a display device.

### BACKGROUND

Typically, a touch display panel includes a display substrate, a touch substrate disposed on the display substrate, and an organic insulating layer disposed between the display substrate and the touch substrate.

### SUMMARY

Embodiments of the present disclosure provide a touch display panel and a display device. the technical solutions are as follows.

In one aspect, a touch display panel is provided. The touch display panel includes a display substrate, wherein the display substrate includes:
a base substrate, having a display region and a peripheral region surrounding the display region;
a plurality of pixel units disposed on a side of the base substrate, wherein the plurality of pixel units are disposed in the display region;
a plurality of dimming portions disposed on a side, away from the base substrate, of the plurality of pixel units, wherein an orthographic projection of each of the dimming portions on the base substrate is overlapped with an orthographic projection of a light-emitting region of a corresponding one of the pixel units on the base substrate, and light from the light-emitting region is exited through the dimming portion;
a first barrier structure disposed on a side of the base substrate, wherein the first barrier structure is disposed in the peripheral region and an orthographic projection of the first barrier structure on the base substrate surrounds the display region; and
a first filling portion disposed on a side of the base substrate, wherein the first filling portion is disposed on a target side of the first barrier structure, the target side of the first barrier structure including at least one of a side, close to the display region, of the first barrier structure or a side, away from the display region, of the first barrier structure;
wherein the first filling portion and the plurality of dimming portions are disposed in a same layer.

In some embodiments, in film layer structures in the display substrate, a total thickness of film layer structures disposed on the target side of the first barrier structure is less than a total thickness of film layer structures disposed at a position of the first barrier structure.

In some embodiments, the first barrier structure includes a first barrier dam and a second barrier dam, wherein the first barrier dam is closer to the display region with respect to the second barrier dam, and a height of the first barrier dam is less than a height of the second barrier dam;
a total thickness of film structures between the first barrier dam and the second barrier dam and a total thickness of film structures disposed on a side, away from the display region, of the second barrier dam are both less than a total thickness of film structures at a position of the first barrier dam; and
the first filling portion is disposed between the first barrier dam and the second barrier dam and on a side, away from the display region, of the second barrier dam.

In some embodiments, a total thickness of film structures disposed on a side, close to the display region, of the first barrier dam is greater than the total thickness of the film structures at the position of the first barrier dam, and the first filling portion is not disposed on the side, close to the display region, of the first barrier dam.

In some embodiments, an orthographic projection of the dimming portion on a reference plane is in an approximate positive trapezoidal structure, wherein the reference plane is perpendicular to a bearing surface of the base substrate, and the positive trapezoidal structure has a first surface close to a side of the base substrate, a second surface away from a side of the base substrate, and a side surface connecting the first surface and the second surface;
wherein light irradiated to the side surface is exited after being converged.

In some embodiments, an area of an orthographic projection of the dimming portion on the base substrate is positively correlated with an area of the light-emitting region of the corresponding pixel unit.

In some embodiments, the plurality of pixel units include a plurality of first pixel units, a plurality of second pixel units, and a plurality of third pixel units; and the plurality of dimming portions include a plurality of first dimming portions corresponding to the plurality of first pixel units, a plurality of second dimming portions corresponding to the plurality of second pixel units, and a plurality of third dimming portions corresponding to the plurality of third pixel units;
wherein an area of a light-emitting region of the first pixel unit is larger than an area of a light-emitting region of the second pixel unit, and the area of the light-emitting region of the second pixel unit is larger than an area of a light-emitting region of the third pixel unit; wherein an area of an orthographic projection of the first dimming portion on the base substrate is larger than an area of an orthographic projection of the second dimming portion on the base substrate, and the area of the orthographic projection of the second dimming portion on the base substrate is greater than an area of an orthographic projection of the third dimming portion on the base substrate.

In some embodiments, the touch display panel includes: a plurality of second filling portions; wherein the plurality of second filling portions are disposed between the display region and the first barrier structure, and the plurality of second filling portions are closer to the display region relative to the first barrier structure.

In some embodiments, the plurality of second filling portions include a plurality of first sub-filling portions, a plurality of second sub-filling portions, and a plurality of third sub-filling portions; wherein
an orthographic projection of the first sub-filling portion on the base substrate and the orthographic projection of the first dimming portion on the base substrate have a same area and a same shape, an orthographic projection of the second sub-filling portion on the base substrate and the orthographic projection of the second dimming portion on the base substrate have a same area and a same shape, and an orthographic projection of the third sub-filling portion on the base substrate and the orthographic projection of the third dimming portion on the base substrate have a same area and a same shape; and
the plurality of second filling portions and the plurality of dimmer portions are arranged in a same manner, and the plurality of second filling portions and the plurality of dimmer portions are disposed in a same layer.

In some embodiments, the touch display panel further includes: a first organic insulating layer disposed on a side, away from the base substrate, of the plurality of dimming portions and the first filling portion; and
a refractive index of the dimming portion is greater than a refractive index of the first organic insulating layer, and light irradiated to an interface between the dimming portion and the first organic insulating layer is converged.

In some embodiments, the base substrate further has a via region and a transition region surrounding the via region, wherein and the display region surrounds the transition region; and the display substrate further includes:
a second barrier structure disposed on a side of the base substrate, wherein the second barrier structure is disposed in the transition region, and an orthographic projection of the second barrier structure on the base substrate surrounds the via region; and
a third filling portion disposed on a side of the base substrate, wherein the third filling portion is disposed on a target side of the second barrier structure, the target side of the second barrier structure including at least one of a side, close to the via region, of the second barrier structure or a side, away from the via region, of the second barrier structure;
wherein the third filling portion and the plurality of dimming portions are disposed in a same layer.

In some embodiments, the second barrier structure includes a third barrier dam and at least one fourth barrier dam that are disposed successively along a side away from the display region; wherein
a thickness of a film layer structure between any two adjacent barrier dams of the third barrier dam and the at least one fourth barrier dam is less than a thickness of a film layer structure at a position of either of the third barrier dam and the fourth barrier dam; and
the third fill portion is disposed between any two adjacent barrier dams of the third barrier dam and the at least one fourth barrier dam.

In some embodiments, the display substrate further includes: a first organic functional layer disposed on a side of the base substrate, wherein the first organic functional layer is disposed in the display region and the transition region; and
the display substrate further includes a first post spacer disposed on a side, close to the display region, of the third barrier dam and a second post spacer disposed between the third barrier dam and the at least one fourth barrier dam;
wherein the first organic functional layer is broken at at least one of the first post spacer and the second post spacer.

In some embodiments, the display substrate includes: a buffer layer, an active layer, a first gate insulator layer, a first gate layer, a second gate insulator layer, a second gate layer, an inter-level layer dielectric layer, a first source-drain layer, a first planarization layer, a second source-drain layer, a second planarization layer, an anode layer, a pixel definition layer, a support layer, a light-emitting film layer, a cathode layer, and an package film layer that are successively laminated along a direction away from the base substrate; wherein
the light-emitting film layer includes the first organic functional layer, a second organic functional layer, and a light-emitting pattern, wherein the first organic functional layer includes at least a hole-transporting layer and an electron-transporting layer, and the second organic functional layer includes at least a hole-injection layer and an electron-injection layer; and
the package film layer includes a first inorganic package layer, an organic package layer, and a second inorganic package layer that are successively laminated, wherein the first inorganic package layer and the second inorganic package layer are disposed in the display region, the peripheral region, and the transition region, and the organic package layer is disposed in the display region.

In some embodiments, each of the first post spacer and the second post spacer includes at least a target film layer;
wherein the target film layer is disposed in the first source-drain layer, wherein an orthographic projection of the target film layer on a reference plane is in an I shape, the reference plane being perpendicular to a bearing surface of the base substrate.

In some embodiments, the target film layer includes a first metal layer, a second metal layer, and a third metal layer that are successively laminated along the direction away from the base substrate;
wherein an etching rate of the second metal layer is greater than an etching rate of the first metal layer and greater than an etching rate of the third metal layer.

In some embodiments, the touch display panel further includes: a touch substrate, wherein the touch substrate includes a first touch electrode layer, a second organic insulating layer, and a second touch electrode layer that are disposed on a light-exiting side of the display substrate and laminated successively; wherein
one of the first touch electrode layer and the second touch electrode layer includes bridging electrodes of a plurality of first touch electrodes, and the other of the first touch electrode layer and the second touch electrode layer includes body electrodes of the plurality of first touch electrodes and a plurality of second touch electrodes, each of the bridging electrodes and each of the body electrodes being electrically connected by a via in the second organic insulating layer; and
a material of the second organic insulating layer is an organic material.

In some embodiments, the touch substrate further includes: a plurality of first touch signal lines and a plurality of second touch signal lines; wherein
each of the first touch signal lines is connected to one of the first touch electrodes, and each of the second touch signal lines is connected to one of the second touch electrodes; and
an orthographic projection of each of the plurality of first touch signal lines and the plurality of second touch signal lines on the base substrate is at least partially overlapped with the orthographic projection of the first barrier structure on the base substrate and is at least partially overlapped with the orthographic projection of the first filling portion on the base substrate.

In some embodiments, an overlapping position of the touch signal line and the first barrier structure, an extension direction of the touch signal line is intersected with an extension direction of the first barrier structure; and
at an overlapping position of the touch signal line and the first filling portion, the extension direction of the touch signal line is intersected with an extension direction of the first filling portion.

In some embodiments, the touch display panel further includes a third organic insulating layer disposed on a side, away from the display substrate, of the touch substrate and a color filter layer;
wherein the color filter layer includes a plurality of color resistors and a black matrix disposed between adjacent color resistors of the plurality of color resistors, and an orthographic projection of each of the color resistors on the base substrate covers the light-emitting region of a corresponding one of the pixel units.

In another aspect, a touch display panel is provided. The touch display panel includes: a display substrate and a first organic insulating layer disposed on a side of the display substrate; wherein the display substrate includes:
a base substrate, having a display region and a peripheral region surrounding the display region;
a plurality of pixel units disposed on a side of the base substrate, wherein the plurality of pixel units are disposed in the display region;
a plurality of dimming portions disposed on a side, away from the base substrate, of the plurality of pixel units, wherein an orthographic projection of each of the dimming portions on the base substrate is overlapped with an orthographic projection of a light-emitting region of a corresponding one of the pixel units on the base substrate, and light from the light-emitting region is exited through the dimming portion;
a first barrier structure disposed on a side of the base substrate, wherein the first barrier structure is disposed in the peripheral region and an orthographic projection of the first barrier structure on the base substrate surrounds the display region; and
a first filling portion disposed on a side of the base substrate, wherein the first filling portion is disposed on a target side of the first barrier structure, the target side of the first barrier structure including at least one of a side, close to the display region, of the first barrier structure or a side, away from the display region, of the first barrier structure;
wherein the first filling portion and the plurality of dimming portions are disposed in a same layer.

In some embodiments, the touch display panel further includes: a touch substrate disposed on a side, away from the display substrate, of the first organic insulating layer, wherein the touch substrate includes a touch electrode layer, the touch electrode layer including a touch electrode and a touch signal line electrically connected to the touch electrode; wherein
an orthographic projection of the touch signal line on the base substrate is at least partially overlapped with an orthographic projection of the first barrier structure on the base substrate, and is at least partially overlapped with an orthographic projection of the first filling portion on the base substrate; and
at an overlapping position of the touch signal line and the first barrier structure, an extension direction of the touch signal line is intersected with an extension direction of the first barrier structure; and at an overlapping position of the touch signal line and the first filling portion, the extension direction of the touch signal line is intersected with an extension direction of the first filling portion.

In still another aspect, a display device panel is provided. The display device includes a power supply assembly and a touch display panel as described above;
wherein the power supply assembly is configured to supply power to the touch display panel.

### BRIEF DESCRIPTION OF DRAWINGS

For clearer descriptions of the technical solutions in the embodiments of the present disclosure, the following briefly introduces the accompanying drawings to be required in the descriptions of the embodiments. Apparently, the accompanying drawings in the following description show merely some embodiments of the present disclosure, and persons of ordinary skills in the art may still derive other drawings from these accompanying drawings without creative efforts.
FIG. 1 is a schematic structural diagram of a touch display panel according to some embodiments of the present disclosure;
FIG. 2 is a schematic diagram of a partial cross-portion of a touch display panel according to some embodiments of the present disclosure;
FIG. 3 is a schematic diagram of a partial cross-portion of another touch display panel according to some embodiments of the present disclosure;
FIG. 4 is a schematic diagram of a partial cross-portion of yet another touch display panel according to some embodiments of the present disclosure;
FIG. 5 is a schematic diagram where a first barrier structure is exposed according to some embodiments of the present disclosure;
FIG. 6 is a schematic diagram where a first touch electrode layer of a touch substrate is formed on an exposed first barrier structure according to some embodiments of the present disclosure;
FIG. 7 is a schematic diagram of a residual touch electrode material according to some embodiments of the present disclosure;
FIG. 8 is a schematic diagram of a partial cross-portion of a further touch display panel according to some embodiments of the present disclosure;
FIG. 9 is a top view of a partial structure of a touch display panel according to some embodiments of the present disclosure;
FIG. 10 is a schematic diagram of the touch display panel shown in FIG. 9 in a region A;
FIG. 11 is another schematic diagram of the touch display panel shown in FIG. 9 in a region A;
FIG. 12 is yet another schematic diagram of the touch display panel shown in FIG. 9 in a region A;
FIG. 13 is yet still another schematic diagram of the touch display panel shown in FIG. 9 in a region A;
FIG. 14 is a schematic diagram of a partial cross-portion of yet still another touch display panel according to some embodiments of the present disclosure;
FIG. 15 is a schematic diagram of a partial cross-portion of a touch substrate according to some embodiments of the present disclosure;
FIG. 16 is a top view of a touch substrate according to some embodiments of the present disclosure;
FIG. 17 is a schematic diagram of a partial cross-portion of a display substrate according to some embodiments of the present disclosure; and
FIG. 18 is a schematic structural diagram of a display device according to some embodiments of the present disclosure;

### DETAILED DESCRIPTION

The present disclosure is described in further detail with reference to the accompanying drawings, to clearly present the objects, technical solutions, and advantages of the present disclosure.

In the related art, a touch substrate includes a first touch electrode and a second touch electrode that are insulated from each other to achieve a touch function of a touch display panel. The display substrate includes a barrier structure that is configured to block the overflow of organic materials from a display region of the display substrate.

However, a height of the barrier structure is usually high, and thus a top of the barrier structure is exposed by an organic insulating layer, and the organic insulating layer is not continuous at the location of the barrier structure and has rough edges. As a result, when preparing a first touch electrode layer in the touch panel substrate, a residual touch electrode material remains in the discontinuous region of the organic insulating layer, and this residual touch electrode material causes different touch electrodes to short-circuit, which leads to poor touch performance of the touch panel display.

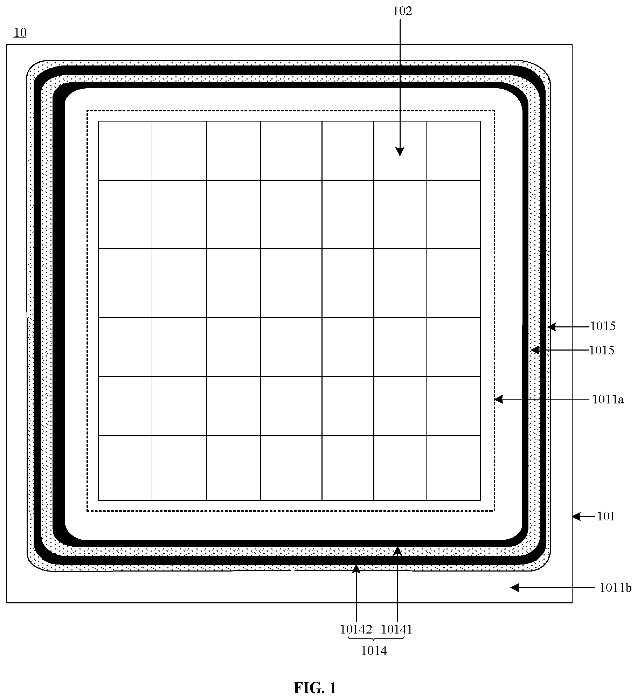

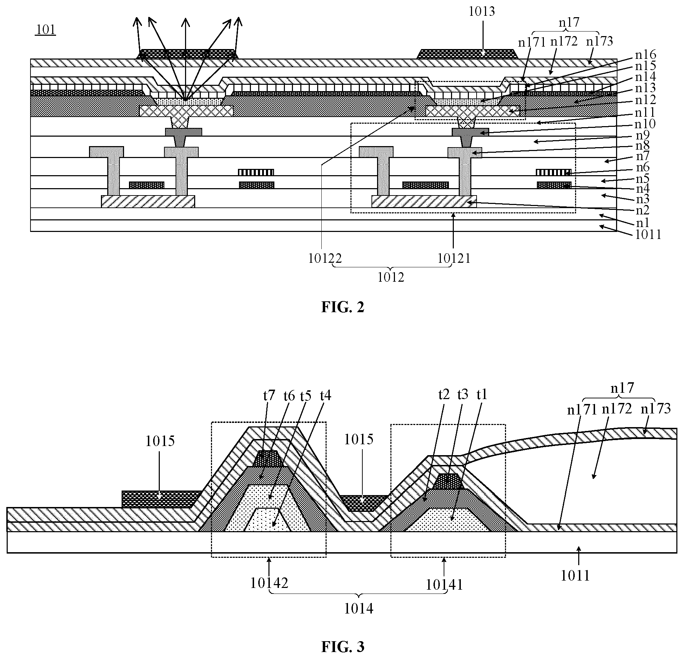

FIG. 1 is a schematic structural diagram of a touch display panel according to some embodiments of the present disclosure. FIG. 2 is a schematic diagram of a partial cross-portion of a touch display panel according to some embodiments of the present disclosure. FIG. 3 is a schematic diagram of a partial cross-portion of another touch display panel according to some embodiments of the present disclosure. Referring to FIG. 1 to FIG. 3, a touch display panel 10 includes a display substrate 101. The display substrate 101 includes a base substrate 1011, a plurality of pixel units 1012, a plurality of dimming portions 1013, a first barrier structure 1014, and a first filling portion 1015.

Referring to FIG. 1, the base substrate 1011 has a display region 1011a and a peripheral region 1011b surrounding the display region 1011a. The plurality of pixel units 1012 are disposed on a side of the base substrate 1011 and are disposed in the display region 1011a. An orthographic projection of each of the plurality of dimming portions 1013 on the base substrate 1011 covers an orthographic projection of a light-emitting region of the corresponding pixel unit 1012 on the base substrate 1011, and light from the light-emitting region exits through the dimming portion 1013.

The plurality of dimming portions 1013 are in one-to-one correspondence with the plurality of pixel units 1012, and each of the dimming portions 1013 dims the light emitted from its corresponding pixel unit 1012 to increase an amount of light emitted from the pixel unit 1012, such that the luminance of the touch panel 10 is increased, and thus the display effect is improved. Optionally, the dimming portion 1013 converges light from an edge region of the pixel unit 1012, such that the amount of light forward output from the pixel unit 1012 is improved.

The first barrier structure 1014 is disposed on a side of the base substrate 1011 and is disposed in the peripheral region 1011b. An orthographic projection of the first barrier structure 1014 on the base substrate 1011 surrounds the display region 1011a. That is, with reference to FIG. 1, this first barrier structure 1014 surrounds the plurality of pixel units 1012.

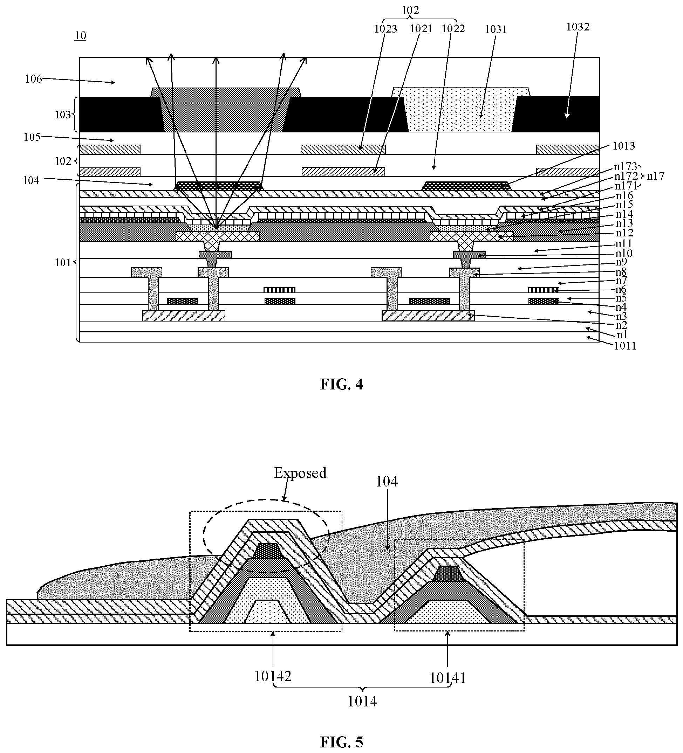

It should be noted that referring to FIG. 4, the touch display panel 10 further includes a touch substrate 102. An insulating layer is disposed between the touch substrate 102 and the display substrate 101. To achieve the bending effect of the touch display panel 10, the insulating layer between the touch substrate 102 and the display substrate 101 is made to be an organic insulating layer (a first organic insulating layer 104 as described below). Further, the touch display panel 10 includes a color filter layer 103 disposed on a side, away from the display substrate 101, of the touch substrate 102. The color filter layer 103 includes a black matrix 10312. An orthographic projection of the black matrix 10312 on the base substrate 1011 is disposed between adjacent pixel units 1012, and light irradiated to the black matrix 10312 cannot exit. To reduce a distance between the pixel unit 1012 and the black matrix 10312 and to improve a viewable angle of the exiting light, a thickness of the first organic insulating layer 104 between the touch substrate 102 and the display substrate 101 is made to be thinner.

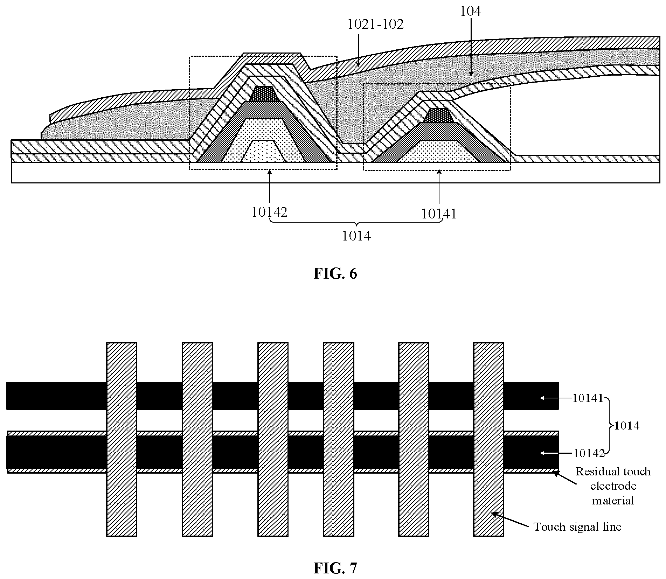

However, with reference to FIG. 5, in a case where the thickness of the first organic insulating layer 104 is designed to be thinner, the first organic insulating layer 104 cannot completely cover the first barrier structure 1014 (a top of the second barrier dam 1014210142 of the first barrier structure 1014 in FIG. 5 is exposed), and an edge of the first organic insulating layer 104 is more rough at a position where the first barrier structure 1014 is exposed. Further, with reference to FIG. 6, the first touch electrode layer 10211021 of the touch substrate 102 is disposed on a side, away from the display substrate 101, of the first organic insulating layer 104. However, in using an etching process to etch a thin film of the touch electrode and thereby forming the first touch electrode layer 1021, a residue of touch electrode material remains at the exposed position of the first barrier structure 1014 (the etching is not clean). As a result, referring to FIG. 7, this residual touch electrode material leads to short-circuits of different touch signal lines, which in turn leads to short-circuits of different touch electrodes, and thus the touch performance of the touch display panel 10 is poor.

In some embodiments of the present disclosure, to solve the above technical problems, referring to FIGS. 1 and 3, the touch display panel 10 includes the first filling portion 1015 disposed on a side of the base substrate 1011 and on a target side of the first barrier structure 1014. The target side of the first barrier structure 1014 includes at least one of a side, close to the display region 1011a, of the first barrier structure 1014 or a side, away from the display region 1011a, of the first barrier structure 1014.

Because an upper surface of the first barrier structure 1014 is typically higher than upper surfaces of film layers in regions on both sides of the first barrier structure 1014, the upper surfaces of the film layers in the regions on both sides of the first barrier structure 1014 are raised by designing the first filling portion 1015 on the target side of the first barrier structure 1014. That is, because the first filling portion 1015 has a certain thickness, a step between the upper surface of the first barrier structure 1014 and the upper surfaces of the film layers in the regions on both sides of the first barrier structure 1014 is reduced.

As a result, the first organic insulating layer 104 formed on the display substrate 101 covers the first barrier structure 1014 without causing the top of the first barrier structure 1014 to be exposed. That is, the film layer of the first organic insulating layer 104 is a continuous film layer, such that during the process of subsequently preparing the first touch electrode layer 10211021 in the touch substrate 102, there is no touch electrode material residue. In this way, the short-circuits of different touch signal lines are avoided, such that the short-circuits of different touch electrodes are avoided, and thus the touch performance of the touch display panel 10 is improved.

In some embodiments of the present disclosure, the first filling portion 1015 and the plurality of dimming portions 1013 are disposed in the same layer. Being disposed in the same layer indicates using the same material and being prepared by a one-time patterning process. By causing the first filling portion 1015 and the plurality of dimming portions 1013 to be disposed in the same layer, the process steps in preparing the touch display panel 10 are reduced, and thus the preparation efficiency is improved.

In summary, some embodiments of the present disclosure provide a touch display panel that includes the first filling portion disposed on the target side of the first barrier structure. The first filling portion serves to provide a raising effect, such that the first organic insulating layer formed subsequently is capable of completely covering the first barrier structure, and thus the residual touch electrode material is prevented from remaining in the touch substrate formed on the side, away from the display substrate, of the first organic insulating layer. In this way, the short-circuits of different touch electrodes are avoided, and thus the touch performance of the touch display panel is improved.

In some embodiments of the present disclosure, in the film layer structures in the display substrate 101, a total thickness of the film layer structures on the target side of the first barrier structure 1014 is less than a total thickness of the film layer structures at the position of the first barrier structure 1014.

Optionally, the first barrier structure 1014 has a first side close to the display region 1011a, and a second side away from the display region 1011a. Assuming that the total thickness of the film layer structures, disposed on the first side of the first barrier structure 1014, in the display substrate 101 is not less than the total thickness of the film layer structures disposed at the position of the first barrier structure 1014, there is no need to design the first filling portion 1015 on the first side of the first barrier structure 1014. Assuming that the total thickness of the film layer structures, disposed on the second side of the first barrier structure 1014, in the display substrate 101 is less than the total thickness of the film layer structures disposed at the position of the first barrier structure 1014, the second side of the first barrier structure 1014 is designed with the first filling portion 1015.

In some embodiments of the present disclosure, this first barrier structure 1014 is an annular structure surrounding the display region 1011a, which is configured to block the overflow of organic materials in the display substrate 101 that is disposed in a region enclosed by the first barrier structure 1014. Referring to FIGS. 1 and 3, the first barrier structure 1014 includes a first barrier dam 10141 and a second barrier dam 10142. The first barrier dam 10141 is closer to the display region 1011a with respect to the second barrier dam 10142, and a height of the first barrier dam 10141 is smaller than a height of the second barrier dam 10142.

By providing the two barrier dams and designing a thickness of the second barrier dam 10142 away from the display region 1011a to be greater than a thickness of the first barrier dam 10141 closer to the display region 1011a, the overflow of the organic materials within the region enclosed by this first barrier structure 1014 is further prevented. In some embodiments, this first barrier structure 1014 includes one barrier dam or more than two barrier dams, which is not limited herein.

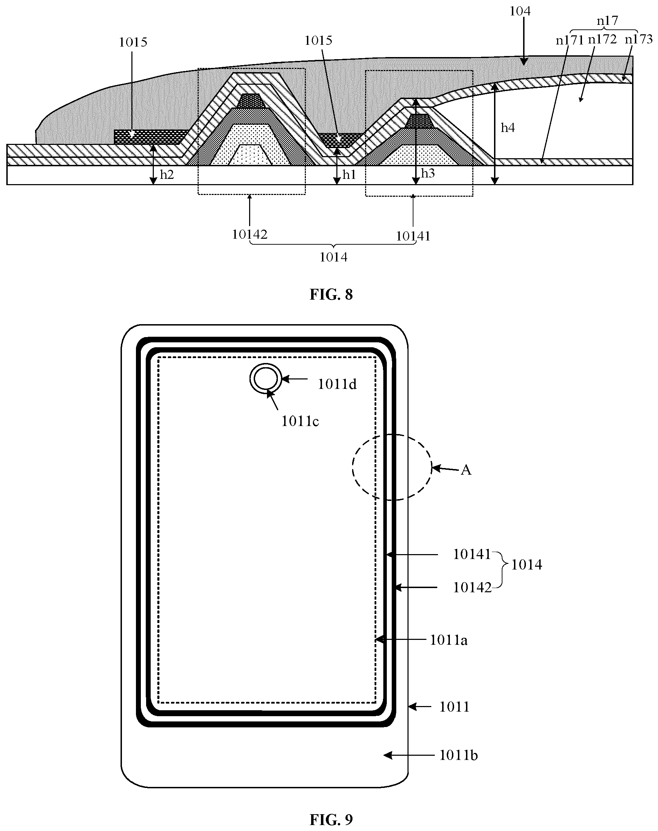

Referring to FIG. 8, a total thickness h1 of film layer structures between the first barrier dam 10141 and the second barrier dam 10142, and a total thickness h2 of film layer structures disposed on a side, away from the display region 1011a, of the second barrier dam 10142 are both smaller than a total thickness h3 of film layer structures at a position where the first barrier dam 10141 is disposed. Moreover, the first filling portion 1015 is disposed between the first barrier dam 10141 and the second barrier dam 10142, and is disposed on the side, away from the display region 1011a, of the second barrier dam 10142.

As a result, the first filling portion 1015 is capable of raising a portion between the first barrier dam 10141 and the second barrier dam 10142, and raising the side, away from the display region 1011a, of the second barrier dam 10142, such that the subsequently formed first organic insulating layer 104 is disposed on the raised film layer surface. As a result, referring to FIG. 8, even if the thickness of the first organic insulating layer 104 is thin, the top of the second barrier dam 10142 is not revealed after the organic material is leveled, such that there is no residue of the touch electrode material in the touch electrode layer in the subsequently formed touch substrate 102, and thus the touch performance of the touch display panel 10 is ensured.

Referring to FIG. 8, a total thickness h4 of the film layer structures disposed on the side, close to the display region 1011a, of the first barrier dam 10141 is greater than the total thickness h3 of the film layer structures disposed at the position of the first barrier dam 10141. The first filling portion 1015 is not disposed on the side, close to the display region 1011a, of the first barrier dam 10141.

Because the total thickness h4 of the film layer structures disposed on the side, close to the display region 1011a, of the first barrier dam 10141 is large, there is no need to provide the raising effect by the first filling portion 1015, and there is no need to provide the first filling portion 1015 on the side, close to the display region 1011a, of the first barrier dam 10141.

Referring to FIG. 2, the orthographic projection of the dimming portion 1013 on a reference plane has an approximate positive trapezoidal structure. The reference plane is perpendicular to a bearing surface of the base substrate 1011. The positive trapezoidal structure has a first surface close to a side of the base substrate 1011, a second surface away from a side of the base substrate 1011, and a side connecting the first surface and the second surface. An orthographic projection of the second surface on the base substrate 1011 is within an orthographic projection of the first surface on the base substrate 1011. The approximate positive trapezoidal structure is an apclose axisymmetric figure.

The positive trapezoidal structure refers to a structure of which the transversals at any position of the side are all at equal angles to the first surface. The approximate positive trapezoidal structure refers to a structure in which there is a small difference in the angles between the transversal lines of the side at different positions and the first surface, possibly due to errors in the manufacturing process.

Optionally, the angle between the side of the positive trapezoidal structure and the first surface ranges from 70° (degrees) to 80°.

The main function of the dimming portion 1013 is to converge light from an edge of the light-emitting region of the pixel unit 1012 to improve the light output. The light from the edge of the light-emitting region of the pixel units 1012 is irradiated to the side of the dimming portion 1013, and the light irradiated to the side is exited from an opening region of the touch display panel 10 after convergence. Meanwhile, light in the middle of the light-emitting region of the pixel unit 1012 is irradiated to the second surface of the dimming portion 1013, and the light irradiated to the second surface is also exited from the opening region of the touch display panel 10.

It should be noted that even though the light irradiated to the second surface is dispersed, the dispersed light is still exited from the opening region of the touch display panel 10, and thus the light output is not reduced due to the dispersion of light.

Alternatively, the orthographic projection of the dimming portion 1013 on the reference plane is in other shapes, which is not limited herein, as long as the dimming portion 1013 is capable of achieving the function of converging the light from the edge of the light-emitting region of the pixel unit 1012.

Optionally, an area of the orthographic projection of the dimming portion 1013 on the base substrate 1011 is positively correlated with an area of the light-emitting region of the corresponding pixel unit 1012. That is, the larger the area of the light-emitting region of the pixel unit 1012 is, the larger the area of the orthographic projection of the dimming portion 1013 on the base substrate 1011 is; the smaller the area of the light-emitting region of the pixel unit 1012 is, the smaller the area of the orthographic projection of the dimming portion 1013 on the base substrate 1011 is.

The plurality of pixel units 1012 include a plurality of first pixel units, a plurality of second pixel units, and a plurality of third pixel units. The plurality of dimming portions 1013 include a plurality of first dimming portions corresponding to the plurality of first pixel units, a plurality of second dimming portions corresponding to the plurality of second pixel units, and a plurality of third dimming portions corresponding to the plurality of third pixel units.

Optionally, an area of a light-emitting region of the first pixel unit is larger than an area of a light-emitting region of the second pixel unit, and the region of the light-emitting region of the second pixel units is larger than an area of a light-emitting region of the third pixel unit. Accordingly, an area of an orthographic projection of the first dimming portion on the base substrate is larger than an area of an orthographic projection of the second dimming portion on the base substrate 1011, and the area of the orthographic projection of the second dimming portion on the base substrate 1011 is larger than an area of an orthographic projection of the third dimming portion on the base substrate 1011.

For example, the first pixel unit is a blue pixel unit, the second pixel unit is a red pixel unit, and the third pixel unit is a green pixel unit.

It should be noted that the plurality of pixel units 1012 include a plurality of fourth pixel units in addition to the plurality of first pixel units, the plurality of second pixel units, and the plurality of third pixel units described above. The fourth pixel units are pixel units of other colors. For example, the fourth pixel units are yellow pixel units. Accordingly, the plurality of dimming portions 1013 include fourth dimming portions corresponding to the fourth pixel units.

In the embodiments of the present disclosure, the organic layer in the display substrate 101 is confined to the side, close to the display region 1011a, of the first barrier structure 1014. Moreover, thicknesses of film layer structures on both sides of the display substrate 101 at a boundary position of the display region 1011a vary more, such that a slope of the display substrate 101 at the boundary position of the display region 1011a is steeper. As a result, during the subsequently formed first organic insulating layer 104 is leveled at the boundary position of the display region 1011a, the first organic insulating material that is supposed to be retained in the display region 1011a flows from the steeper boundary position of the display region 1011a to regions outside the display region 1011a, and thus the dimming portion 1013 that is disposed at the edge of the display region 1011a and is within the display region 1011a is exposed by the first organic insulating layer 104, which affects the dimming performance of the dimming portion 1013.

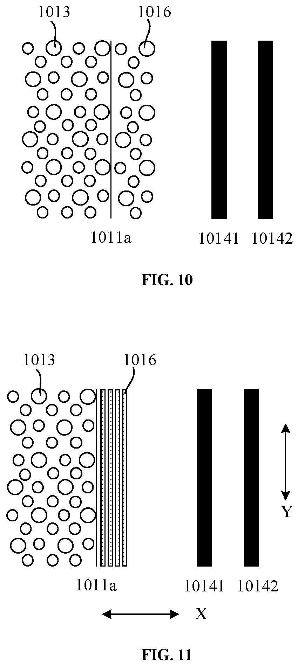

FIG. 9 is a top view of a partial structure of a touch display panel according to some embodiments of the present disclosure. FIG. 10 is a schematic diagram of the touch display panel shown in FIG. 9 in a region A. In conjunction with FIG. 9 and FIG. 10, to address the above technical issues, the display substrate 101 further includes a plurality of second filling portions 1016. The plurality of second filling portions 1016 are disposed between the display region 1011a and the first barrier structure 1014, and the plurality of second filling portions 1016 are closer to the display region 1011a relative to the first barrier structure 1014.

By providing the plurality of second filling portions 1016 in positions between the display region 1011a and the first barrier structure 1014 and closer to the display region 1011a, film layer structures at the position are raised, and the first organic insulating layer 104 serves as a barrier effect on the first organic insulating material when subsequently leveling, such that the dimming portion of the display region 1011a 1013 is prevented from being exposed. Moreover, the slope of the display substrate 101 is steeper at the boundary position of the display region 1011a and slower at the position between the display region 1011a and the first barrier structure 1014, such that even if the first organic insulating layer 104 flows outside the display region 1011a when leveling, the second filling portion 1016 is not exposed, which has less influence on the subsequent preparation of other film layers.

Optionally, the associated design of the plurality of second filling portions 1016 is consistent with the plurality of dimming portions 1013, which improves the consistency of the patterns of the film layers on both sides of the display region 1011a, and thus the display effect at the edges of the display region 1011a is improved.

Exemplarily, the plurality of second filling portions 1016 include a plurality of first sub-filling portions, a plurality of second sub-filling portions, and a plurality of third sub-filling portions. An orthographic projection of the first sub-filling portion on the base substrate 1011 and the orthographic projection of the first dimming portion on the base substrate 1011 have the same area and shape. An orthographic projection of the second sub-filling portion on the base substrate 1011 and the orthographic projection of the second dimming portion on the base substrate 1011 have the same area and shape. An orthographic projection of the third sub-filling portion on the base substrate 1011 and the orthographic projection of the third dimming portion on the base substrate 1011 have the same area and shape. The plurality of second filling portions 1016 and the plurality of dimmer portions 1013 are arranged in the same manner.

In some embodiments of the present disclosure, the second filling portion 1016 is designed differently from the dimming portion 1013, as long as the filling portion is provided in the display region 1011a and the first barrier structure 1014 and close to the display region 1011a.

Referring to FIG. 11, taking a region at the right side of the display region 1011a as an example, the plurality of second filling portions 1016 include a plurality of strip-like structures arranged along a first direction X and extending along a second direction Y. Optionally, a length of each strip-like structure along the first direction X (i.e., a width of the strip-like structure) ranges from 8 micrometers to 20 micrometers, and a distance between two adjacent strip-like structures along the first direction X ranges from 10 micrometers to 30 micrometers. The first direction X and the second direction Y are perpendicular. The first direction X is a pixel row direction of the display substrate 10, and the second direction Y is a pixel column direction of the display substrate 10.

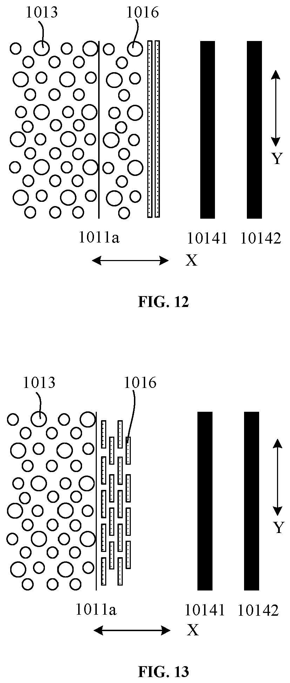

Referring to FIG. 12, the plurality of second filling portions 1016 include a plurality of first sub-fillings corresponding to the first dimming portions, a plurality of second sub-fillings corresponding to the second dimming portions, a plurality of third sub-fillings corresponding to the third dimming portions, and a plurality of strip-like structures arranged along the first direction and extending along the second direction. The associated designs of the first sub-filling portions, the second sub-filling portions, and the third sub-filling portions are the same as those of the respective dimming portions 1013. A length of each strip-like structure along the first direction X (i.e., a width of the strip-like structure) ranges from 8 micrometers to 20 micrometers, and a distance between two adjacent strip-like structures along the first direction X ranges from 10 micrometers to 30 micrometers.

Referring to FIG. 13, the plurality of second filling portions 1016 include a plurality of groups of strip-like groups arranged along the first direction X. Each group of strip-like groups includes a plurality of strip-like strictures spaced apart and arranged along the second direction Y and extending along the second direction Y. Adjacent two of strip-like groups are staggered. A length of each strip-like structure along the second direction Y ranges from 50 micrometers to 100 micrometers, and a distance between two adjacent strip-like structures arranged along the second direction Y is less than 100 micrometers. A distance between two adjacent groups of strip-like structures ranges from 10 micrometers to 40 micrometers.

In addition, the plurality of second filling portions 1016 and the plurality of dimming portions 1013 are disposed in the same layer. That is, the plurality of second filling portions 1016 and the plurality of dimming portions 1013 are prepared using the same material by the same preparation process. By causing the second filling portions 1016 and the plurality of dimming portions 1013 to be disposed in the same layer, the process steps in preparing the touch display panel 10 are reduced, and thus the preparation efficiency is improved.

In some embodiments of the present disclosure, referring to FIG. 4, the touch display panel 10 further includes a first organic insulating layer 104 disposed on a side, away from the base substrate 1011, of the plurality of dimming portions 1013 and the first filling portion 1015. A refractive index of the dimming portion 1013 is greater than that of the first organic insulating layer 104, and light irradiated to an interface between the dimming portion 1013 and the first organic insulating layer 104 is converged or diverged.

Referring to FIG. 4, the light irradiated to the interface between the side of the dimming portion 1013 and the first organic insulating layer 104 is converged, and the light irradiated to the interface between the first surface of the dimming portion 1013 and the first organic insulating layer 104 is diverged.

Optionally, the refractive index of the dimming portion 1013 ranges from 1.6 to 1.9. the refractive index of the first organic insulating layer 104 ranges from 1.2 to 1.4.

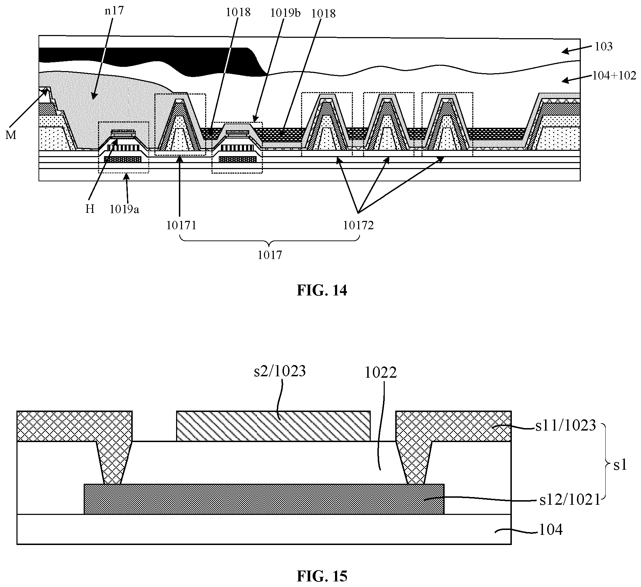

In some embodiments of the present disclosure, referring to FIG. 9, the base substrate 1011 further includes a via region 1011c and a transition region 1011d surrounding the via region 1011c. The display region 1011a surrounds the transition region 1011d. The via region 1011c has a via or a blind hole therein, and a camera is provided in the via or the blind hole for capturing images. The transition region 1011d is a transition region between the via region 1011c and the display region 1011a. Referring to FIG. 14, the display substrate 101 further includes a second barrier structure 1017 disposed on a side of the base substrate 1011. The second barrier structure 1017 is disposed in the transition region 1011d, and an orthographic projection of the second barrier structure 1017 on the base substrate 1011 includes the via region 1011c.

By providing the second barrier structure 1017 in the transition region 1011d, the organic material in the display region 1011a is prevented from overflowing the via region 1011c, which ensures a reliable setup of the camera.

Referring to FIG. 14, the touch display panel 10 further includes a third filling portion 1018 disposed on a side of the base substrate 1011. The third filling portion 1018 is disposed on a target side of the second barrier structure 1017. The target side of the second barrier structure 1017 includes at least one of a side, close to the via region, of the second barrier structure 1017 1011c or a side, away from one of the via regions 1011c, of the second barrier structure 1017.

Because an upper surface of the second barrier structure 1017 is typically higher than upper surfaces of film layers in regions on both sides of the second barrier structure 1017, by designing the third filling portion 1018 on the target side of the second barrier structure 1017, a surface, away from the base substrate 1011, of the third filling portion 1018 is made to be the upper surfaces of the film layers in the regions on both sides of the second barrier structure 1017. That is, because the third filling portion 1018 has a certain thickness, a step between the upper surface of the second barrier structure 1017 and the upper surfaces of the film layers in the regions on both sides of the second barrier structure 1017 is reduced.

As a result, the first organic insulating layer 104 formed on the display substrate 101 is capable of covering the second barrier structure 1017 without causing a top of the second barrier structure 1017 to be exposed. That is, the first organic insulating layer 104 is a continuous film layer at the position of the second barrier structure 1017. During the process of subsequently preparing the first touch electrode layer 10211021 in the touch substrate 102, there is no touch electrode material residue, such that different touch signal lines are avoided to be shortcircuited, and thus the short-circuits of different touch electrodes are avoided, and the touch performance of the touch display panel 10 is ensured.

In some embodiments of the present disclosure, the third filling portion 1018, the first filling portion 1015, the second filling portion 1016, and the dimming portion 1013 are disposed in the same layer. The process steps in preparing the touch display panel 10 are thus reduced and the preparation efficiency is improved.

Referring to FIG. 14, the second barrier structure 1017 includes a third barrier dam 10171 and at least one fourth barrier dam 10172 that are successively disposed along a direction away from the display region 1011a. In the third barrier dam 10171 and the at least one fourth barrier dam 10172, a thickness of a film layer structure between any two adjacent barrier dams is less than a thickness of a film layer structure at a position of either of the fourth barrier dam 10172. The third fill portion 1018 is disposed between any two adjacent barrier dams of the third barrier dam 10171 and the at least one fourth barrier dam 10172.

As a result, the third filling portion 1018 is capable of raising a portion between any two adjacent barrier dams of the third barrier dam 10171 and the at least one fourth barrier dam 10172, and the subsequently formed first organic insulating layer 104 is formed on a surface of the raised film layer. Even if the thickness of the first organic insulating layer 104 is thin, the top of the third barrier dam 10171 or the top of the fourth barrier dam 10172 is not exposed after the first organic insulating material is leveled. In this way, there is no touch electrode material residue in the touch electrode layer in the subsequently formed touch substrate 102, and thus the touch performance of the touch display panel 10 is ensured.

In some embodiments of the present disclosure, the display substrate 101 further includes a first organic functional layer M disposed on a side of the base substrate 1011. The first organic functional layer M is disposed in the display region 1011a and the transition region 1011d. The display substrate 101 further includes a first post spacer 1019a disposed on a side, close to the display region 1011a, of the third barrier dam 10171, and a second post spacer 1019b disposed between the third barrier dam 10171 and the at least one fourth barrier dam 10172. The first organic functional layer M is broken at at least one of the first post spacer 1019a and the second post spacer 1019b.

It should be noted that water vapor and oxygen are transported along the first organic functional layer M to the display region 1011a. The first organic functional layer M is broken at at least one of the post spacers, and therefore, even if the water vapor and oxygen enter the first organic functional layer M from a side surface, in the via region 1011c, of the display panel, the water vapor and oxygen are blocked by the at least one of the post spacers and instead of entering the display region 1011a along the first organic functional layer M. Further, the first organic functional layer M is broken at both the first post spacer 1019a and the second post spacer 1019b, such that water vapor and oxygen are further prevented from entering the display region 1011a. As a result, the pixel units 1012 of the display substrate 101 disposed in the display region 1011a are prevented from corroding by water vapor and oxygen, and thus the display effect is ensured.

In some embodiments of the present disclosure, a material of the first organic functional layer M is an organic material. Because the organic material is susceptible to absorbing water and oxygen, the water vapor and oxygen enter the display substrate 101 from the first organic functional layer M on the side surface, in the via region 1011c, of the display substrate 101. By causing the first organic functional layer M to be broken at at least one of the first post spacer 1019a and the second post spacer 1019b, the water vapor and oxygen are prevented from entering the display region 1011a along the first organic functional layer M.

Optionally, both the first post spacer 1019a and the second post spacer 1019b are annular structures surrounding the via region 1011c. The display substrate 101 includes a plurality of first post spacers 1019a and a plurality of second post spacers 1019b. Exemplarily, the display substrate 101 includes four first post spacers 1019a and seven second post spacers 1019b.

In some embodiments of the present disclosure, referring to FIGS. 2 and 4, the display substrate 101 includes a buffer layer n1, an active layer n2, a first gate insulator (GI) n3, a first gate layer n4, a second gate insulator n5, a second gate layer n6, an inter-level dielectric layer (ILD) n7, a first source-drain layer n8, a first planarization layer (PLN) n9, a second source-drain layer n10, a second planarization layer n11, an anode layer (anode) n12, a pixel definition layer (PDL) n13, a support layer (PS) n14, a light-emitting film layer n15, a cathode layer n16, and a package film layer n17.

The first gate layer n4, the second gate layer n6, the first source-drain layer n8, the first planarization layer n9, the second source-drain layer n10, and the second planarization layer n11 are disposed in the display region 1011a. The first gate insulator layer n3, the second gate insulator layer n5, and the inter-level dielectric layer n7 are disposed in the transition region 1011d and the display region 1011a.

In some embodiments of the present disclosure, each of the first post spacer 1019a and the second post spacer 1019b includes a target film layer H. The target film layer H is disposed in the first source-drain layer n8, and an orthographic projection of the target film layer H on a reference plane is in an I shape. By designing the target film layer H in each of the first post spacer 1019a and the second post spacer 1019b in the I shape, it is convenient to make the first organic functional layer M break at the first post spacer 1019a and the second post spacer 1019b, such that the water vapor and oxygen are prevented from entering the display region 1011a.

Optionally, the target film layer H includes a first metal layer, a second metal layer, and a third metal layer that are successively laminated in the direction away from the base substrate 1011. An etching rate of the second metal layer is greater than an etching rate of the first metal layer and greater than an etching rate of the third metal layer.

In embodiments of the present disclosure, because the etching rate of the second metal layer is large and the etching rates of the first metal layer and the third metal layer are small, the target film layer H is made to be in the I shape based on differences in the etching rates of the individual metal layers.

Exemplarily, assuming that the target film layer H and the first source-drain layer n8 are disposed in the same layer, because the first source-drain layer n8 and the second source-drain layer n10 are typically made of three-layers of laminated titanium (Ti), aluminum (Al), and titanium, the first metal layer and the third metal layer in the target film layer H are both made of titanium and the second metal layer is made of aluminum

In some embodiments of the present disclosure, the first post spacer 1019a and the second post spacer 1019b include other film layers in addition to the target film layer H. For example, each of the first post spacer 1019a and the second post spacer 1019b includes a gate pattern disposed in the same layer as the first gate layer n4, and a gate pattern disposed in the same layer as the second gate layer n6.

In some embodiments of the present disclosure, the film layers included in each post spacer in the display substrate 101 are different, or in some embodiments, the film layers in the individual post spacers in the display substrate 101 are the same, which is not limited herein. Regardless of the film layers included in the various post spacers in the display substrate 101, as long as it is ensured that the first organic functional layer M is broken at at least one post spacer in the display substrate 101.

In some embodiments of the present disclosure, each pixel unit 1012 in the display substrate 101 disposed in the display region 1011a includes a pixel circuit 10121 and a light-emitting unit 10122. The pixel circuit 10121 includes a storage capacitor and at least one thin film transistor.

Optionally, the active layer n2 includes a plurality of active patterns. The first gate layer n4 includes a plurality of first gate patterns. The second gate layer n6 includes a plurality of second gate patterns. The first source-drain layer n8 includes a plurality of source electrodes and a plurality of drain electrodes in one-to-one correspondence with the plurality of source electrodes. The second source-drain layer n10 includes a plurality of connecting patterns.

One active pattern, one first gate pattern, one source electrode, and one drain electrode form one thin film transistor, and the source electrode and the corresponding drain electrode of each thin film transistor are connected to the active pattern. One first gate pattern and one second gate pattern form one storage capacitor.

Referring to FIG. 2, the anode layer n12, the light-emitting film layer n15, and the cathode layer n16 in the display substrate 101 form light-emitting units 10122 of the plurality of pixel units 1012. The anode layer n12 includes a plurality of anode patterns. The light-emitting film layer n15 includes the first organic functional layer M, a second organic functional layer, and a light-emitting pattern (only the light-emitting pattern is shown in the figures for representing the light-emitting film layer n15). The anode layer n12, the second organic functional layer, and the light-emitting pattern are all disposed in the display region 1011a. The cathode layer n16 is disposed in the transition region 1011d and the display region 1011a.

The anode layer n12, the second organic functional layer, and the light-emitting pattern being all disposed in the display region 1011a indicates that the anode layer n12, the second organic functional layer, and the light-emitting pattern are disposed in the display region 1011a only and not in the transition region 1011d. The first organic functional layer M includes at least a hole-transporting layer and an electron-transporting layer, and the second organic functional layer includes at least a hole-injection and an electron-injection layer.

Referring to FIG. 2, the pixel definition layer n13 in the display substrate 101 has a plurality of hollowed-out regions, each of which is configured to expose the anode pattern of one of the pixel units 1012. The anode pattern of each pixel unit 1012 is connected to the drain electrode of the thin film transistor by a connecting pattern.

In some embodiments of the present disclosure, the package film layer n17 includes a first inorganic package layer n171, an organic package layer n172, and a second inorganic package layer n173 that are successively laminated. The first inorganic package layer n171 and the second inorganic package layer n173 are disposed in the display region 1011a, the peripheral region 1011b, and the transition region 1011d. The organic package layer n172 is disposed in the display region 1011a.

The organic package layer n172 is disposed only in the display region 1011a and is not disposed in the peripheral region 1011b and the transition region 1011d, which is the main reason that the total thickness of the film layer structures of the display region 1011a in the display substrate 101 is greater than the total thickness of the film layer structures of the peripheral region 1011b and greater than the total thickness of the film layer structures of the transition region 1011d.

The material of the organic package layer n172 is an organic material. Therefore, the water vapor and oxygen are prevented from entering the display region 1011a from this organic package layer n172 by making the organic package layer n172 not disposed in the peripheral region 1011b and the transition region 1011d, such that the package effect is ensured.

Optionally, the first inorganic package layer n171 is made of silicon nitrogen oxide (SiNO), and the second inorganic package layer n173 is made of silicon nitride (SiN). The organic package layer n172 is made of a resin material. The resin is a thermoplastic resin or a thermoplastic resin. The thermoplastic resin includes an acrylic (PMMA) resin, and the thermoset resin includes an epoxy resin.

Optionally, the first inorganic package layer n171 and the second inorganic package layer n173 are prepared using a chemical vapor deposition (CVD) method. The organic package layer n172 is prepared using an ink jet printing (IJP) method.

In some embodiments of the present disclosure, the first barrier dam 10141 includes a first pattern t1, a second pattern t2, and a third pattern t3 that are successively laminated along a side away from the base substrate 1011. The second barrier dam 10142 includes a fourth pattern t4, a fifth pattern t5, a sixth pattern t6, and a seventh pattern t7 that are successively laminated along the side away from the base substrate 1011. The fourth pattern t4 is disposed in the first planarization layer n9, the first pattern t1 and the fifth pattern t5 are disposed in the second planarization layer n11, the second pattern t2 and the sixth pattern t6 are disposed in the pixel definition layer n13, and the third pattern t3 and the seventh pattern t7 are disposed in the support layer n14.

That is, the second barrier dam 10142 has an additional layer of pattern disposed in the first planarization layer n9 relative to the first barrier dam 10141, such that the thickness of the second barrier dam 10142 is greater than the thickness of this first barrier dam 10141, and thus the overflow of the organic layer is avoided.

Optionally, a height of the third barrier dam 10171 and a height of the fourth barrier dam 10172 are equal. Exemplarily, each of the third barrier dam 10171 and the fourth barrier dam 10172 includes the pattern of the first planarization layer n9, the pattern of the second planarization layer n11, and the pattern of the pixel definition layer n13. In some embodiments, the height of the third barrier dam 10171 and the height of the fourth barrier dam 10172 are different, which are not limited herein.

In some embodiments of the present disclosure, referring to FIG. 4, the touch display panel 10 further includes a touch substrate 102. The touch substrate 102 includes a first touch electrode layer 1021, a second organic insulating layer 1022, and a second touch electrode layer 1023 disposed on a light-exiting side of the display substrate 101 and successively laminated.

One of the first touch electrode layer 1021 and the second touch electrode layer 1023 includes a plurality of bridging electrodes s12 of the first touch electrodes s1, and the other of the first touch electrode layer 1021 and the second touch electrode layer 1023 includes a plurality of body electrodes s11 of the first touch electrodes s1, and a plurality of second touch electrodes s2. The bridging electrode and the body electrode are electrically connected by a via in the second organic insulating layer 1022. The material of the second organic insulating layer 1022 is an organic material, which facilitates the bending of the touch display panel 10.

Optionally, referring to FIG. 15, the bridging electrodes of the plurality of first touch electrodes s1 are disposed in the first touch electrode layer 10211021, and the body electrodes s11 of the plurality of first touch electrodes s1 and the plurality of second touch electrodes s2 are disposed in the second touch electrode layer 1023. Alternatively, the body electrodes s11 of the plurality of first touch electrodes s1 and the plurality of second touch electrodes s2 are disposed in the first touch electrode layer 10211021, and the bridge electrodes s12 of the plurality of first touch electrodes s1 are disposed in the second touch electrode layer 1023.

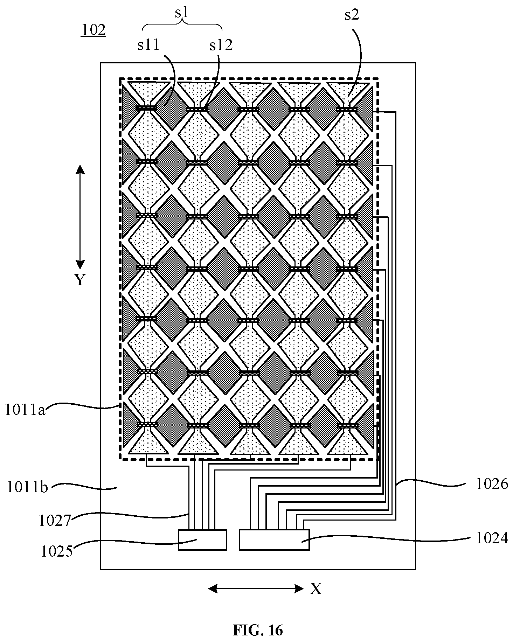

Referring to FIG. 16, the plurality of first touch electrodes s1 in the touch display panel 10 are arranged along the second direction Y, and the plurality of second touch electrodes s2 are arranged along the first direction X. The bridging electrode s12 of the first touch electrode s1 is disposed in a region overlapped with an orthographic projection of the second touch electrode s2.

Referring to FIG. 16, the touch substrate 102 further includes a driving circuit 1024 and a detecting circuit 1025 that are disposed in the peripheral region 1011b. The driving circuit 1024 is electrically connected to the plurality of first touch electrodes s1 and is configured to provide driving signals for the first touch electrodes s1. The detecting circuit 1025 is electrically connected to the second touch electrodes s2 and is configured to detect inductive signals, received from the second touch electrodes s2, between the first touch electrodes s1 and the second touch electrodes s2.

In the process that the driving circuit 1024 provides the driving signal for the first touch electrode s1, the detecting circuit 1025 is capable of detecting the inductive signal between the first touch electrode s1 and the second touch electrode s2 received from the second touch electrode s2. In a case where the user's finger is close to the touch display panel 10, the detecting circuit 1025 is capable of detecting a change in the inductive signal at a position of the user's finger, and determining the position at which the inductive signal has changed as a touch position.

Optionally, because the driving circuit 1024 is electrically connected to the first touch electrode s1, the first touch electrode s1 is a transmitting (TX) electrode. because the detecting circuit 1025 is electrically connected to the second touch electrode s2, the second touch electrode s2 is a sensing (RX) electrode.

In some embodiments of the present disclosure, the touch substrate 102 further includes a plurality of first touch signal lines 1026 and a plurality of second touch signal lines 1027. Each first touch signal line 1026 is connected to one of the first touch electrodes s1, and each second touch signal line 1027 is connected to one of the second touch electrodes s2.

Optionally, one end of each first touch signal line 1026 is connected to the driving circuit 1024 and the other end is connected to one of the first touch electrodes s1. One end of each second touch signal line 1027 is connected to the detecting circuit 1025 and the other end is connected to one of the second touch electrodes s2. That is, the driving circuit 1024 is connected to the first touch electrode s1 by the first touch signal line 1026, and the detecting circuit 1025 is connected to the second touch electrode s2 by the second touch signal line 1027.

Typically, the driving circuit 1024 and the detecting circuit 1025 are disposed on a side, away from the display region 1011a, of the first barrier structure 1014, and the first touch electrode s1 and the second touch electrode s2 are disposed in the display region 1011a. Therefore, to achieve the connection between the driving circuit 1024 and the first touch electrode s1 and the connection between the detecting circuit 1025 and the second touch electrode s2, the first touch signal line 1026 and the second touch signal line 1027 need to cross the first barrier structure 1014. That is, an orthographic projection of each of the plurality of first touch signal lines 1026 and the plurality of second touch signal lines 1027 on the base substrate 1011 is at least partially overlapped with the orthographic projection of the first barrier structure 1014 on the base substrate 1011. Exemplarily, at the overlapping position of the touch signal line and the first barrier structure 1014, an extension direction of the touch signal lines is intersected with an extension direction of the first barrier structure 1014, such as the extension direction of the touch signal lines is perpendicular to the extension direction of the first barrier structure 1014.

Further, the first filling portion 1015 disposed on the target side of the first barrier structure 1014 is an annular structure, whereby the plurality of first touch signal lines 1026 and the plurality of second touch signal lines 1027 also cross the first filling portion 1015. That is, the orthographic projection of each control signal line of the plurality of first touch signal lines 1026 and the plurality of second touch signal lines 1027 on the base substrate 1011 is at least partially overlapped with the orthographic projection of the first filling portion 1015 on the base substrate 1011. Exemplarily, at the overlapping position of the touch signal line and the first filling portion 1015, an extension direction of the touch signal line is intersected with an extension direction of the first filling portion 1015, such as the extension direction of the touch signal line is perpendicular to the extension direction of the first filling portion 1015.

In some embodiments of the present disclosure, referring to FIG. 4, the touch display panel 10 further includes a third organic insulating layer 105 disposed on a side, away from the display substrate 101, of the touch substrate 102, and a color filter layer 103. The color filter layer 103 includes a plurality of color resistors 10311, and black matrixes (BM) 10312 disposed between adjacent color resistors 10311. An orthographic projection of each of the color resistors 10311 on the base substrate 1011 covers the light-emitting region of one corresponding pixel unit 1012. The opening region of the touch display panel 10 refers to a region, where the black matrix 10312 is not provided, in the color filter layer 103.

In some embodiments of the present disclosure, the sum of a thickness of the first organic insulating layer 104, a thickness of the second organic insulating layer 1022, and a thickness of the third organic insulating layer 105 affects a distance between the light-emitting unit 10122 of the pixel cell 1012 and the black matrix 10312 in a direction perpendicular to a bearing surface of the base substrate 1011. The greater the distance between the light-emitting unit 10122 and the black matrix 10312 in the direction perpendicular to the bearing surface of the base substrate 1011, the smaller the angular range of the light that can be exited in the light emitted from the light-emitting unit 10122; and the smaller the distance between the light-emitting unit and the black matrix 10312 in the direction perpendicular to the bearing surface of the base substrate 1011, the larger the angular range of the light can be exited in the light emitted from the light-emitting unit 10122.

Accordingly, to increase the angular range of the light that can be exited in the light emitted from the light-emitting unit 10122, the sum of the thicknesses of the first organic insulating layer 104, the second organic insulating layer 1022, and the third organic insulating layer 105 is reduced. For example, the thickness of the first organic insulating layer 104, the second organic insulating layer 1022, and the third organic insulating layer 105 are made to be smaller.

However, in the case where the thickness of the first organic insulating layer 104 is small, the first barrier structure 1014 or the second barrier structure 1017 is exposed, which in turn results in the presence of a touch electrode material residue in the first touch electrode layer 10211021 in the touch substrate 102. In the embodiments of the present disclosure, by providing the first filling portion 1015 and the third filling portion 1018, the surface of the film layer in the region next to the first barrier structure 1014 and the second barrier structure 1017 is raised. In this way, when the organic material of the first organic insulating layer 104 is leveled, the first organic insulating layer 104 is made to cover the first barrier structure 1014 and the second barrier structure 1017, such that the touch electrode material residue is avoided, and thus the touch performance of the touch display panel 10 is ensured.

In some embodiments of the present disclosure, the dimming portion 1013 is disposed on a side, away from the base substrate 1011, of the touch substrate 102, or on a side, away from the base substrate 1011, of the color filter layer 103. In some embodiments, the touch substrate 102 is disposed on the side, away from the base substrate 1011, of the color filter layer 103. That is, the positions of the dimming portion 1013, the touch substrate 102, and the color filter layer 103 are switched arbitrarily, which is not limited herein.

Referring to FIG. 4, the touch display panel 10 further includes a fourth organic insulating layer 106, which is disposed on the side, away from the display substrate 101, of the color filter layer 103, and the fourth organic insulating layer 106 protects the color filter layer 103.

Optionally, the first organic insulating layer 104, the second organic insulating layer 1022, the third organic insulating layer 105, and the fourth organic insulating layer 106 are made of optical clear adhesive (OC).

In summary, some embodiments of the present disclosure provide a touch display panel that includes the first filling portion disposed on the target side of the first barrier structure. The first filling portion serves the raising effect, such that e the first organic insulating layer formed subsequently is capable of completely covering the first barrier structure, which avoids the residual touch electrode material in the touch substrate formed on the side, away from the display substrate, of the first organic insulating layer, such that the short-circuits of different touch electrodes are avoided, and thus the touch performance of the touch display panel is ensured.

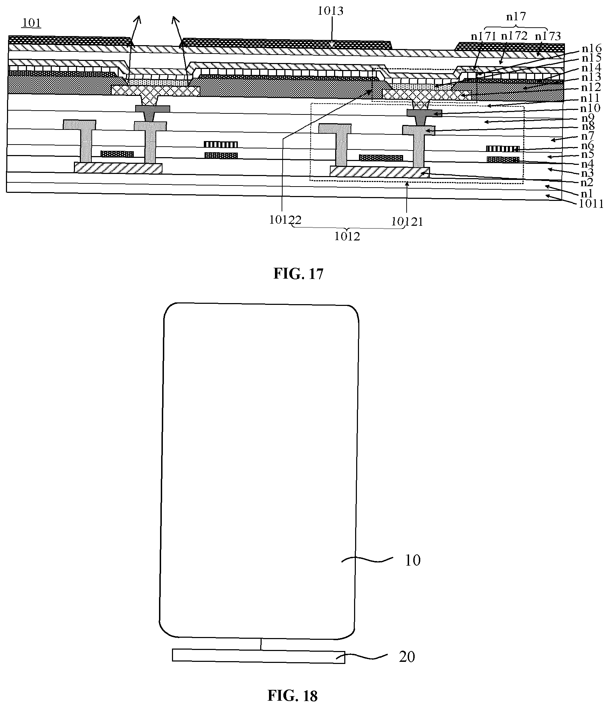

FIG. 17 is a schematic diagram of a partial cross-portion of a display substrate according to some embodiments of the present disclosure. In conjunction with FIG. 1, FIG. 8, and FIG. 17, the touch display panel 10 includes a display substrate 101 and a first organic insulating layer 104 disposed on a side of the display substrate 101. The display substrate 101 includes a base substrate 1011, a plurality of pixel units 1012, a plurality of dimming portions 1013, a first barrier structure 1014, and a first filling portion 1015.

Referring to FIG. 1, the base substrate 1011 has a display region 1011a and a peripheral region 1011b surrounding the display region 1011a. The plurality of pixel units 1012 are disposed on a side of the base substrate 1011 and are disposed in the display region 1011a. In conjunction with FIG. 17 and FIG. 8, the plurality of dimming portions 1013 are disposed on a side, away from the base substrate 1011, of the plurality of pixel units 1012. The first organic insulating layer 104 is disposed on a side, away from the base substrate 1011, of the plurality of dimming portions 1013. Light from a light-emitting region of the pixel unit 1012 is exited after converging by an interface between the dimming portion 1013 and the first organic insulating layer 104. Refractive indexes of the dimming portion 1013 and the first organic insulating layer 104 are different.

Referring to FIG. 2, the refractive index of the dimming portion 1013 is greater than the refractive index of the first organic insulating layer 104. The plurality of dimming portions 1013 are on one-to-one correspondence to the plurality of pixel units 1012, and each dimming portion 1013 converges the light emitted from the corresponding pixel unit 1012, such that the amount of light emitted from the pixel unit 1012 is increased, and thus luminance of the touch display panel 10 is improved, which improves the display effect. Optionally, the dimming portion 1013 converges the light from an edge region of the pixel unit 1012, such that the amount of light forward output from the pixel unit 1012 is improved.

In some embodiments, referring to FIG. 17, the refractive index of the dimming portion 1013 is less than the refractive index of the first organic insulating layer 104. The dimming portion 1013 is disposed between adjacent pixel units 1012 in the plurality of pixel units 1012, and the dimming portion 1013 converges the light from the edge region of the pixel unit 1012 to increase the amount of light forward output from the pixel units 1012.

The first barrier structure 1014 is disposed on a side of the base substrate 1011 and is disposed in the peripheral region 1011b. An orthographic projection of the first barrier structure 1014 on the base substrate 1011 surrounds the display region 1011a. That is, with reference to FIG. 1, this first barrier structure 1014 surrounds the plurality of pixel units 1012.

It should be noted that referring to FIG. 4, the touch display panel 10 further includes a touch substrate 102, and a color filter layer 103 disposed on a side, away from the display substrate 101, of the touch substrate 102. The color filter layer 103 includes a black matrix 10312. An orthographic projection of the black matrix 10312 on the base substrate 1011 is disposed between adjacent pixel units 1012, and light irradiated onto the black matrix 10312 cannot exit. To reduce a distance between the pixel unit 1012 and the black matrix 10312 and to improve a viewable angle of the exiting light, a thickness of the first organic insulating layer 104 between the touch substrate 102 and the display substrate 101 is made to be thinner.

However, with reference to FIG. 5, in a case where the thickness of the first organic insulating layer 104 is designed to be thinner, the first organic insulating layer 104 cannot completely cover the first barrier structure 1014 (a top of the second barrier dam 1014210142 of the first barrier structure 1014 in FIG. 5 is exposed), and the first organic insulating layer 104 is rough at a position at which the first organic insulating layer 104 is exposed. Further, with reference to FIG. 6, the first touch electrode layer 10211021 of the touch substrate 102 is disposed on a side, away from the display substrate 101, of the first organic insulating layer 104. However, during using an etching process to etch the touch electrode film and thereby forming the first touch electrode layer 1021, the first barrier structure 1014 has a residue of touch electrode material at the exposed position (the etching is not clean). As a result, referring to FIG. 7, this residual touch electrode material leads to short-circuits of different touch signal lines, which leads to short-circuits of different touch electrodes, and thus the touch performance of the touch display panel 10 is poor.

In some embodiments of the present disclosure, to solve the above technical problems, referring to FIGS. 1 and 8, the touch display panel 10 includes the first filling portion 1015 disposed on a side of the base substrate 1011 and on a target side of the first barrier structure 1014. The target side of the first barrier structure 1014 includes at least one of a side, close to the display region 1011a, of the first barrier structure 1014 or a side, away from the display region 1011a, of the first barrier structure 1014.

Because an upper surface of the first barrier structure 1014 is typically higher than upper surfaces of film layers in regions on both sides of the first barrier structure 1014, the upper surfaces of the film layers in the regions on both sides of the first barrier structure 1014 are raised by designing the first filling portion 1015 on the target side of the first barrier structure 1014. That is, because the first filling portion 1015 has a certain thickness, a step between the upper surface of the first barrier structure 1014 and the upper surfaces of the film layers in the regions on both sides of the first barrier structure 1014 is reduced.

As a result, the first organic insulating layer 104 formed on the display substrate 101 is capable of covering the first barrier structure 1014 without causing the top of the first barrier structure 1014 to be exposed. That is, the film layer of the first organic insulating layer 104 is a continuous film layer, such that there is no touch electrode material residue in subsequently preparing the first touch electrode layer 10211021 in the touch substrate 102. In this way, the short-circuits of different touch signal lines are avoided, such that the short-circuits of different touch electrodes are avoided, and thus the touch performance of the touch display panel 10 is ensured.

In some embodiments of the present disclosure, the first filling portion 1015 and the plurality of dimming portions 1013 are disposed in the same layer. Being disposed in the same layer indicates using the same material and being prepared by a one-time patterning process. By causing the first filling portion 1015 and the plurality of dimming portions 1013 to be disposed in the same layer, the process steps in preparing the touch display panel 10 are reduced and the preparation efficiency is improved.

In some embodiments of the present disclosure, the touch substrate 102 includes touch electrode layers (e.g., the first touch electrode layer 1021 and the second touch electrode layer 1022 in FIG. 15). The touch electrode layer includes touch electrodes (e.g., the first touch electrode s1 and the second touch electrode s2 in FIG. 16), and touch signal lines electrically connected to the touch electrodes (e.g., the first touch signal line and the second touch signal line in FIG. 16).

An orthographic projection of the touch signal line on the base substrate 1011 is at least partially overlapped with an orthographic projection of the first barrier structure 1014 on the base substrate 1011. At an overlapping position of the touch signal line and the first barrier structure 1014, an extension direction of the touch signal line is intersected with an extension direction of the first barrier structure 1014. For example, the extension direction of the touch signal line is perpendicular to the extension direction of the first barrier structure 1014.

The orthographic projection of the touch signal line on the base substrate 1011 is at least partially overlapped with the orthographic projection of the first filling portion 1015 on the base substrate 1011. At the overlapping position of the touch signal line and the first filling portion 1015, the extension direction of the touch signal line is intersected with the extension direction of the first filling portion 1015. For example, the extension direction of the touch signal line is perpendicular to the extension direction of the first filling portion 1015.

In summary, some embodiments of the present disclosure provide a touch display panel that includes the first filling portion disposed on the target side of the first barrier structure. The first filling portion serves as a raising role, such that the first organic insulating layer formed subsequently is capable of completely covering the first barrier structure. In this way, there is no residue of the touch electrode materials in the touch substrate formed on the side, away from the display substrate, of the first organic insulating layer, such that the short-circuits of different touch electrodes are avoided, and thus the touch performance of the touch display panel is ensured.

It should be noted that since other relevant features in the embodiments of the present disclosure may be referred to the specific descriptions of the above embodiments, the descriptions are not repeated herein for brevity.

FIG. 18 is a schematic structural diagram of a display device according to some embodiments of the present disclosure. Referring to FIG. 18, the display device includes a power supply assembly 20 and a touch display panel 10 as described above. The power supply assembly 20 is configured to power the touch display panel 10.

Optionally, the display device is an OLED display device, a quantum dot light-emitting diodes (QLED) display device, an e-paper, a mobile phone, a tablet computer, a television, a monitor, a laptop computer, a digital photo frame, a navigator, or any other product or component has a display function and fingerprint identification function.

Exemplarily, the display device is an active-matrix organic light-emitting diode (AMOLED) display panel.

Because the display device has essentially the same technical effect as the light-emitting module described above, the technical effects of the display device are not repeated herein for brevity.

The terms used in the detailed description of the present disclosure are merely for interpreting, instead of limiting, the embodiments of the present disclosure. It should be noted that unless otherwise defined, technical or scientific terms used in the embodiments of the present disclosure shall have ordinary meanings understandable by persons of ordinary skill in the art to which the disclosure belongs.

The terms used in the detailed description of the present disclosure are merely for interpreting, instead of limiting, the embodiments of the present disclosure. It should be noted that unless otherwise defined, technical or scientific terms used in the embodiments of the present disclosure shall have ordinary meanings understandable by persons of ordinary skill in the art to which the disclosure belongs. The terms "first," "second," and the like used in the embodiments of the present disclosure are not intended to indicate any order, quantity, or importance, but are merely used to distinguish the different components. The terms "comprise," "include," and derivatives or variations thereof are used to indicate that the element or object preceding the terms covers the element or object following the terms and its equivalents, and shall not be understood as excluding other elements or objects. The terms "connect," "contact," and the like are not intended to be limited to physical or mechanical connections, but may include electrical connections, either direct or indirect connection. The terms "on," "under," "left," and "right" are only used to indicate the relative positional relationship. When the absolute position of the described object changes, the relative positional relationship may change accordingly.

Described above are merely exemplary embodiments of the present disclosure, and are not intended to limit the present disclosure. Therefore, any modifications, equivalent substitutions, improvements, and the like made within the spirit and principles of the present disclosure shall be included in the protection scope of the present disclosure.

## Claims

1. A touch display panel (10), comprising: a display substrate (101), wherein the display substrate (101) comprises:
a base substrate (1011) having a display region (1011a) and a peripheral region (1011b) surrounding the display region (1011a);
a plurality of pixel units (1012) disposed on a side of the base substrate (1011), wherein the plurality of pixel units (1012) are disposed in the display region (1011a);
a plurality of dimming portions (1013) disposed on a side, away from the base substrate (1011), of the plurality of pixel units (1012), wherein an orthographic projection of each of the dimming portions (1013) on the base substrate (1011) is overlapped with an orthographic projection of a light-emitting region of a corresponding one of the pixel units (1012) on the base substrate (1011), and light from the light-emitting region is exited through the dimming portion (1013);
a first barrier structure (1014) disposed on a side of the base substrate (1011), wherein the first barrier structure (1014) is disposed in the peripheral region (1011b) and an orthographic projection of the first barrier structure (1014) on the base substrate (1011) surrounds the display region (1011a); and
a first filling portion (1015) disposed on a side of the base substrate (1011), wherein the first filling portion (1015) is disposed on a target side of the first barrier structure (1014), the target side of the first barrier structure (1014) comprising at least one of a side, close to the display region (1011a), of the first barrier structure (1014) or a side, away from the display region (1011a), of the first barrier structure (1014);
wherein the first filling portion (1015) and the plurality of dimming portions (1013) are disposed in a same layer.

2. The touch display panel according to claim 1, wherein in film layer structures in the display substrate (101), a total thickness of film layer structures disposed on the target side of the first barrier structure (1014) is less than a total thickness of film layer structures disposed at a position of the first barrier structure (1014).

3. The touch display panel according to claim 2, wherein
the first barrier structure (1014) comprises a first barrier dam (10141) and a second barrier dam (10142), wherein the first barrier dam (10141) is closer to the display region (1011a) with respect to the second barrier dam (10142), and a height of the first barrier dam (10141) is less than a height of the second barrier dam (10142);
a total thickness of film structures between the first barrier dam (10141) and the second barrier dam (10142) and a total thickness of film structures disposed on a side, away from the display region (1011a), of the second barrier dam (10142) are both less than a total thickness of film structures at a position of the first barrier dam (10141); and
the first filling portion (1015) is disposed between the first barrier dam (10141) and the second barrier dam (10142) and on a side, away from the display region (1011a), of the second barrier dam (10142).

4. The touch display panel according to claim 3, wherein a total thickness of film structures disposed on a side, close to the display region (1011a), of the first barrier dam (10141) is greater than the total thickness of the film structures at the position of the first barrier dam (10141), and the first filling portion (1015) is not disposed on the side, close to the display region (1011a), of the first barrier dam (10141).

5. The touch display panel according to any one of claims 1 to 4, wherein an orthographic projection of the dimming portion (1013) on a reference plane is in an approximate positive trapezoidal structure, wherein the reference plane is perpendicular to a bearing surface of the base substrate (1011), and the positive trapezoidal structure has a first surface close to a side of the base substrate (1011), a second surface away from a side of the base substrate (1011), and a side surface connecting the first surface and the second surface;
wherein light irradiated to the side surface is exited after being converged.

6. The touch display panel according to any one of claims 1 to 5, wherein an area of an orthographic projection of the dimming portion (1013) on the base substrate (1011) is positively correlated with an area of the light-emitting region of the corresponding the pixel unit (1012).

7. The touch display panel according to claim 6, wherein
the plurality of pixel units (1012) comprise a plurality of first pixel units, a plurality of second pixel units, and a plurality of third pixel units; and
the plurality of dimming portions (1013) comprise a plurality of first dimming portions corresponding to the plurality of first pixel units, a plurality of second dimming portions corresponding to the plurality of second pixel units, and a plurality of third dimming portions corresponding to the plurality of third pixel units;
wherein an area of a light-emitting region of the first pixel unit is larger than an area of a light-emitting region of the second pixel unit, and the area of the light-emitting region of the second pixel unit is larger than an area of a light-emitting region of the third pixel unit;
wherein an area of an orthographic projection of the first dimming portion on the base substrate (1011) is larger than an area of an orthographic projection of the second dimming portion on the base substrate (1011), and the area of the orthographic projection of the second dimming portion on the base substrate (1011) is greater than an area of an orthographic projection of the third dimming portion on the base substrate (1011).

8. The touch display panel according to claim 7, the touch display panel comprising: a plurality of second filling portions (1016);
wherein the plurality of second filling portions (1016) are disposed between the display region (1011a) and the first barrier structure (1014), and the plurality of second filling portions (1016) are closer to the display region (1011a) relative to the first barrier structure (1014).

9. The touch display panel according to claim 8, wherein the plurality of second filling portions (1016) comprise a plurality of first sub-filling portions, a plurality of second sub-filling portions, and a plurality of third sub-filling portions; wherein
an orthographic projection of the first sub-filling portion on the base substrate (1011) and the orthographic projection of the first dimming portion on the base substrate (1011) have a same area and a same shape, an orthographic projection of the second sub-filling portion on the base substrate (1011) and the orthographic projection of the second dimming portion on the base substrate (1011) have a same area and a same shape, and an orthographic projection of the third sub-filling portion on the base substrate (1011) and the orthographic projection of the third dimming portion on the base substrate (1011) have a same area and a same shape; and
the plurality of second filling portions (1016) and the plurality of dimmer portions (1013) are arranged in a same manner, and the plurality of second filling portions (1016) and the plurality of dimmer portions (1013) are disposed in a same layer.

10. The touch display panel according to any one of claims 1 to 9, the touch display panel further comprising: a first organic insulating layer (104) disposed on a side, away from the base substrate (1011), of the plurality of dimming portions (1013) and the first filling portion (1015);
wherein a refractive index of the dimming portion (1013) is greater than a refractive index of the first organic insulating layer (104), and light irradiated to an interface between the dimming portion (1013) and the first organic insulating layer (104) is converged.

11. The touch display panel according to any one of claims 1 to 10, wherein the base substrate (1011) further has a via region (1011c) and a transition region (1011d) surrounding the via region (1011c), wherein the display region (1011a) surrounds the transition region (1011d); and the display substrate (101) further comprises:
a second barrier structure (1017) disposed on a side of the base substrate (1011), wherein the second barrier structure (1017) is disposed in the transition region (1011d), and an orthographic projection of the second barrier structure (1017) on the base substrate (1011) surrounds the via region (1011c); and
a third filling portion (1018) disposed on a side of the base substrate (1011), wherein the third filling portion (1018) is disposed on a target side of the second barrier structure (1017), the target side of the second barrier structure (1017) comprising at least one of a side, close to the via region (1011c), of the second barrier structure (1017) or a side, away from the via region (1011c), of the second barrier structure (1017);
wherein the third filling portion (1018) and the plurality of dimming portions (1013) are disposed in a same layer.

12. The touch display panel according to claim 11, wherein the second barrier structure (1017) comprises a third barrier dam (10171) and at least one fourth barrier dam (10172) that are disposed successively along a side away from the display region (1011a); wherein
a thickness of a film layer structure between any two adjacent barrier dams of the third barrier dam (10171) and the at least one fourth barrier dam (10172) is less than a thickness of a film layer structure at a position of either of the third barrier dam (10171) and the fourth barrier dam (10172); and
the third fill portion (1018) is disposed between any two adjacent barrier dams of the third barrier dam (10171) and the at least one fourth barrier dam (10172).

13. The touch display panel according to claim 12, the display substrate (101) further comprising: a first organic functional layer (M) disposed on a side of the base substrate (1011), wherein the first organic functional layer (M) is disposed in the display region (1011a) and the transition region (1011d); and
the display substrate (101) further comprising a first post spacer (1019a) disposed on a side, close to the display region (1011a), of the third barrier dam (10171) and a second post spacer (1019b) disposed between the third barrier dam (10171) and the at least one fourth barrier dam (10172);
wherein the first organic functional layer (M) is broken at at least one of the first post spacer (1019a) and the second post spacer (1019b).

14. The touch display panel according to claim 13, wherein the display substrate (101) comprises: a buffer layer (n1), an active layer (n2), a first gate insulator layer (n3), a first gate layer (n4), a second gate insulator layer (n5), a second gate layer (n6), an inter-level layer dielectric layer (n7), a first source-drain layer (n8), a first planarization layer (n9), a second source-drain layer (n10), a second planarization layer (n11), an anode layer (n12), a pixel definition layer (n13), a support layer (n14), a light-emitting film layer (n15), a cathode layer (n16), and a package film layer (n17) that are successively laminated along a direction away from the base substrate (1011); wherein
the light-emitting film layer (n15) comprises the first organic functional layer (M), a second organic functional layer, and a light-emitting pattern, wherein the first organic functional layer (M) comprises at least a hole-transporting layer and an electron-transporting layer, and the second organic functional layer comprises at least a hole-injection layer and an electron-injection layer; and
the package film layer (n17) comprises a first inorganic package layer (n171), an organic package layer (n172), and a second inorganic package layer (n173) that are successively laminated, wherein the first inorganic package layer (n171) and the second inorganic package layer (n173) are disposed in the display region (1011a), the peripheral region (1011b), and the transition region (1011d), and the organic package layer (n172) is disposed in the display region (1011a).

15. The touch display panel according to claim 14, wherein each of the first post spacer (1019a) and the second post spacer (1019b) comprises at least a target film layer (H);
wherein the target film layer (H) is disposed in the first source-drain layer (n8), wherein an orthographic projection of the target film layer (H) on a reference plane is in an I shape, the reference plane being perpendicular to a bearing surface of the base substrate (1011).

16. The touch display panel according to claim 15, wherein the target film layer (H) comprises: a first metal layer, a second metal layer, and a third metal layer that are successively laminated along the direction away from the base substrate (1011);
wherein an etching rate of the second metal layer is greater than an etching rate of the first metal layer and greater than an etching rate of the third metal layer.

17. The touch display panel according to any one of claims 1 to 16, the touch display panel (10) further comprising: a touch substrate (102), wherein the touch substrate (102) comprises a first touch electrode layer (1021), a second organic insulating layer (1022), and a second touch electrode layer (1023) that are disposed on a light-exiting side of the display substrate (101) and laminated successively; wherein
one of the first touch electrode layer (1021) and the second touch electrode layer (1023) comprises bridging electrodes of a plurality of first touch electrodes, and the other of the first touch electrode layer (1021) and the second touch electrode layer (1023) comprises body electrodes of the plurality of first touch electrodes and a plurality of second touch electrodes, each of the bridging electrodes and each of the body electrodes being electrically connected by a via in the second organic insulating layer (1022); and
a material of the second organic insulating layer (1022) is an organic material.

18. The touch display panel according to claim 17, wherein the touch substrate (102) further comprises a plurality of first touch signal lines (1026) and a plurality of second touch signal lines (1027); wherein
each of the first touch signal lines (1026) is connected to one of the first touch electrodes, and each of the second touch signal lines (1027) is connected to one of the second touch electrodes; and
an orthographic projection of each of the plurality of first touch signal lines (1026) and the plurality of second touch signal lines (1027) on the base substrate (1011) is at least partially overlapped with the orthographic projection of the first barrier structure (1014) on the base substrate (1011) and is at least partially overlapped with the orthographic projection of the first filling portion (1015) on the base substrate (1011).

19. The touch display panel according to claim 18, wherein at an overlapping position of the touch signal line and the first barrier structure (1014), an extension direction of the touch signal line is intersected with an extension direction of the first barrier structure (1041); and
at an overlapping position of the touch signal line and the first filling portion (1015), the extension direction of the touch signal line is intersected with an extension direction of the first filling portion (1015).

20. The touch display panel according to claim 17, the touch display panel (10) further comprising: a third organic insulating layer (105) disposed on a side, away from the display substrate (101), of the touch substrate (102) and a color filter layer (103);
wherein the color filter layer (103) comprises a plurality of color resistors (10311) and a black matrix (10312) disposed between adjacent color resistors (10311) of the plurality of color resistors (10311), and an orthographic projection of each of the color resistors (10311) on the base substrate (1011) covers the light-emitting region of a corresponding one of the pixel units (1012).

21. A touch display panel (10), comprising: a display substrate (101) and a first organic insulating layer (104) disposed on a side of the display substrate (101); wherein the display substrate (101) comprises:
a base substrate (1011) having a display region (1011a) and a peripheral region (1011b) surrounding the display region (1011a);
a plurality of pixel units (1012) disposed on a side of the base substrate (1011), wherein the plurality of pixel units (1012) are disposed in the display region (1011a);
a plurality of dimming portions (1013) disposed on a side, away from the base substrate (1011), of the plurality of pixel units (1012), wherein the first organic insulating layer (104) is disposed on a side, away from the base substrate (1011), of the plurality of dimming portions (1013), light from a light-emitting region of the pixel unit (1012) is exited after being converged at an interface between the dimming portion (1013) and the first organic insulating layer (104), and a refractive index of the dimming portion (1013) and a refractive index of the first organic insulating layer (104) are different;
a first barrier structure (1014) disposed on a side of the base substrate (1011), wherein the first barrier structure (1014) is disposed in the peripheral region (1011b) and an orthographic projection of the first barrier structure (1014) on the base substrate (1011) surrounds the display region (1011a); and
a first filling portion (1015) disposed on a side of the base substrate (1011), wherein the first filling portion (1015) is disposed on a target side of the first barrier structure (1014), the target side of the first barrier structure (1014) comprising at least one of a side, close to the display region (1011a), of the first barrier structure (1014) or a side, away from the display region (1011a), of the first barrier structure (1014);
wherein the first filling portion (1015) and the plurality of dimming portions (1013) are disposed in a same layer.

22. The touch display panel according to claim 21, the touch display panel (10) further comprising: a touch substrate (102) disposed on a side, away from the display substrate (101), of the first organic insulating layer (104), wherein the touch substrate (102) comprises a touch electrode layer, the touch electrode layer comprising a touch electrode and a touch signal line electrically connected to the touch electrode; wherein
an orthographic projection of the touch signal line on the base substrate (1011) is at least partially overlapped with an orthographic projection of the first barrier structure (1014) on the base substrate (1011), and is at least partially overlapped with an orthographic projection of the first filling portion (1015) on the base substrate (1011); and
at an overlapping position of the touch signal line and the first barrier structure, an extension direction of the touch signal line is intersected with an extension direction of the first barrier structure (1014); and at an overlapping position of the touch signal line and the first filling portion (1015), the extension direction of the touch signal line is intersected with an extension direction of the first filling portion (1015).

23. A display device, comprising: a power supply assembly (20) and the touch display panel (10) as defined in any one of claims 1 to 22;
wherein the power supply assembly (20) is configured to supply power to the touch display panel (10).
